(19) Europäisches Patentamt
European Patent Office
Office européen des brevets

(11) Publication number: **0 043 116**
**B1**

(12) **EUROPEAN PATENT SPECIFICATION**

(45) Date of publication of patent specification: **05.12.84**

(21) Application number: **81104939.4**

(22) Date of filing: **26.06.81**

(51) Int. Cl.³: **G 03 F 7/26,** C 08 F 220/10, C 08 F 220/58, C 08 L 67/06 // H01L21/312

(54) **Negative-working resists for recording high-energy radiation.**

(30) Priority: **27.06.80 US 163470**

(43) Date of publication of application: **06.01.82 Bulletin 82/01**

(45) Publication of the grant of the patent: **05.12.84 Bulletin 84/49**

(84) Designated Contracting States: **DE FR GB**

(56) References cited:
**DE-B-2 507 356**
**DE-B-2 547 792**
**GB-A-1 407 312**
**US-A-3 813 264**
**US-A-3 894 163**

(73) Proprietor: **EASTMAN KODAK COMPANY**
**343 State Street**
**Rochester New York 14650 (US)**

(72) Inventor: **Tan, Zoilo Cheng Ho**
**Kodak Park**
**Rochester New York (US)**
Inventor: **Rauner, Frederick Joseph**
**Kodak Park**
**Rochester New York (US)**
Inventor: **Petropoulos, Constantine Chris**
**Kodak Park**
**Rochester New York (US)**

(74) Representative: **Brandes, Jürgen, Dipl.-Chem. Dr. et al**
**Thierschstrasse 8**
**D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**EP 0 043 116 B1**

Courier Press, Leamington Spa, England.

**Description**

This invention relates to negative-working resists suitable for recording high-energy radiation such as an electron beam. Such resists are comprised of novel acrylic copolymers and are particularly useful in the manufacture of semiconductor devices.

Electron-beam exposure devices have been found to be useful in providing controlled line exposures of submicron dimensions. Such dimensions, accompanied by strict tolerances, are essential to the production of integrated circuit chips. The procedure for such production is to expose a resist layer applied to a suitable substrate to an electron beam having a width of submicron dimensions. After the resist is developed, the substrate not protected by the resist is etched, either by a chemical solution or by a plasma beam. Examples of such procedures, including the exposure and development of the resist, are described in *J. Vac. Sci. Technol.* Vol. 15, No. 3, pp. 960—964 (May/June 1979).

One difficulty with such a procedure is the lack of high quality negative-working resist. The resist must possess high sensitivity to an electron beam of conventional voltage and must also resist deformation and dissolution by the etching process applied to the substrate or base material, usually a semiconductor. More specifically, the resist should be sensitive to an electron beam exposure of $2.0\times10^{-7}$ coulombs/cm$^2$ or less at 10 keV. It should also have submicron resolution capability, thermal stability, and high resistance to etching. Such requirements are particularly difficult to achieve in light of the fact that prior studies have suggested that sensitivities in the $10^{-8}$ coulombs/cm$^2$ range produce thermal instability. (See *J. Vac. Sci. Technol.* Vol. 12, No. 6 pp. 1280—1284 (Nov/Dec 1975) Poly(glycidyl methacrylate-co-ethyl acrylate) is mentioned as a useful resist for electron beam exposure in the aforesaid article in *J. Vac. Sci. Technol.* Vol. 15. However, it is sensitive to an exposure of $2.0\times10^{-7}$ coulombs/cm$^2$ at 10 keV, only at relatively high molecular weights. Furthermore, its resistance to plasma etching is not as good as is desired.

An additional poly(acrylate) described as sensitive to electron-beam exposure is a copolymer of 2-hydroxyethyl acrylate and saturated vinyls such as methyl methacrylate and butyl methacrylate. Examples are listed in British Patent Specification 1,407,312, but as paints rather than as resists. It is interesting to note that this patent disparages copolymers containing hydroxyethyl methacrylate as being too insensitive to be useful.

Therefore, what is desired is a negative-working resist which is sensitive to electron beam exposure of up to $2.0\times10^{-7}$ coulombs/cm$^2$ at 10 keV at molecular weights less than 100,000, have improved plasma etch resistance, and adequate submicron resolution capability.

The present invention provides a negative-working resist having the desired electron-beam sensitivity and improved plasma etch resistance noted above. It also provides a negative-working resist having enhanced thermal stability.

More specifically, the present invention provides a negative-working resist for recording high-energy radiation exposure comprising a copolymer of acrylates and/or methacrylates characterized in that the copolymer has from 50 to 95 mole percent of at least one recurring unit conforming to the structure:

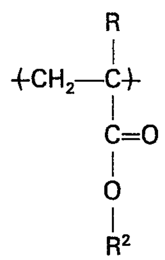

I

and from 5 to 50 mole percent of at least one recurring unit conforming to the structure:

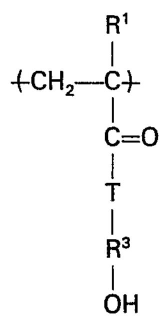

II

wherein

R and $R^1$ are each independently hydrogen or methyl,

$R^2$ is —$R^4$—CH=$CH_2$ or 3-norbornenyl;

$R^3$ and $R^4$ are each independently alkylene having from 1 to 3 carbon atoms; and

T is —O— or —NH—; and

in that said resist is sensitive to exposure with an electron beam of up to $2.0 \times 10^{-7}$ coulombs/$cm^2$ at 10 keV. 10 keV. By 3-norbornenyl we mean a group having the formula

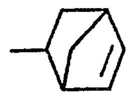

The negative-working resist can be coated on any suitable substrate as a protective coating.

The resists of the invention are hereinafter described primarily as materials useful for exposure with an electron-beam. They are also useful as resists for exposure to other forms of high energy radiation, such as x-ray radiation.

It has been discovered that both enhanced sensitivity and enhanced etch resistance are provided by resists comprising polymers prepared by copolymerizing an acrylate or methacrylate ester of an unsaturated alkyl alcohol and a hydroxyalkyl acrylate or methacrylate. The polymers of the invention have recurring units of the structural formula set forth above. A particularly useful subclass of polymers includes polymers wherein $R^2$ is —$R^4$—CH=$CH_2$. For this subclass, examples of useful $R^3$ and $R^4$ groups include, individually, methylene, ethylene, n-propylene and isopropylene.

Specific preferred examples of polymers of this invention include poly[allyl methacrylate-co-(2-hydroxyethyl methacrylate)]; poly[3-butenyl methacrylate-co-(2-hydroxyethyl methacrylatae)]; poly[3-norbornenyl methacrylate-co-(2-hydroxyethyl methacrylate)]; and poly(allyl methacrylate-co-2-hydroxypropylmethacrylamide).

Other comonomers can be included to form other recurring units in the polymer provided that they are compatible, that is, that they do not interfere with the crosslinking of the polymer. Preferably, to insure maximum sensitivity and etch resistance, recurring units I and II together comprise at least 80 mole percent of the polymer. Most preferably the units I and II comprise 100 mole percent with units II comprising 25 to 30 mole percent, as it has been found that such polymers, by reason of the increased mole percent of hydroxyl groups present, have enhanced plasma etch resistance.

The polymers of the invention are sensitive to an electron-beam of 10 keV at up to $2.0 \times 10^7$ coulombs/$cm^2$. In several cases, they are much more sensitive than this. Such results are achieved for polymers having weight average molecular weights (hereinafter "Mw") that are, in most cases, well below 100,000. Thus, on a per molecular weight basis, the polymers used in the invention comprise the most highly sensitive negative-working electron-beam resists. Electron-beam sensitivities herein described were determined, as is conventional, by exposing identical coatings to increased dosage values and measuring the amount of resist remaining in the exposed area after development. The sensitivity is that dosage required to crosslink enough of the composition to retain 50% of the initial coating thickness.

The molecular weights of useful polymers of the invention can vary widely, as long as the polymer has a low enough viscosity in the solvent of choice to permit it to be coated. It has been found that useful polymers having inherent viscosities of up to 0.3 deciliters per gram, as measured in N,N-dimethylformamide at 25°C. However, low molecular weights tend to reduce the electron-beam sensitivity undesirably. Preferably, therefore, the weight average molecular weight of the polymer, as determined by gel permeation chromatography analysis, is between 20,000 and 200,000. Most preferably, it is between 40,000 and 50,000.

There is some evidence that the polydispersity of the polymer, as measured by the ratio Mw/Mn where Mn is the number average molecular weight, affects inversely the resolution capability of the polymer. Although this is not considered a critical factor, the most preferred examples of the invention have polymers with a polydispersity value of up to 3.0. The polymers useful in the invention in general have a resolution of 0.3 μm line per 1.0 μm space, when exposed to electron beams as described.

The polymers useful in the invention are prepared by conventional synthesis techniques. It should be noted however, that dilute reaction conditions are preferred to avoid undesirable crosslinking. The following preparations are illustrative. The amide monomer of the amide copolymer noted above can be prepared by Preparation No. 17 of British Patent Specification No. 1,463,816.

Preparation No. 1

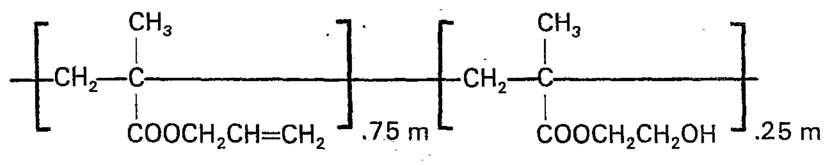

$\overline{Mw}$=41,489; $\overline{Mn}$=14,761; $\overline{MW}/\overline{Mn}$=2.81.

A 3 liter reaction vessel was equipped with a magnetic stirrer, heating mantle, reflux condenser, addition funnel, and nitrogen inlet. A solution of 100 g of allyl methacrylate, 34.4 g of 2-hydroxyethyl methacrylate, and 1.33 g of 2,2′-azobis(2-methyl propionitrile) in 530 ml of 1,2-dichloroethane (DCE) was added dropwise to 2 liters of stirred, refluxing DCE under a nitrogen atmosphere in the aforementioned vessel. The reaction conditions were maintained for 6 hrs after completion of the addition. When cool, the reaction solution was concentrated to 650 ml without heating under a vacuum generated by a water aspirator. The resulting solution was added dropwise to 8 liters of vigorously stirred hexane whereupon the polymer precipitated. The solids were collected on a filter funnel, washed with fresh hexane and dried in vacuo with no heat. 105 g yield.

Elemental analysis:
Calc C 63.8 H 7.90 O 28.3
Found C 63.6 H 8.30 O 28.1

Thermogravimetric analysis: Exotherm @174°C
Weight loss—4% @ 68—134°C; 0.5% @ 134—195°C; 44.5% @ 195—383°C; 49% @ 383—471°C.

Preparation No. 2

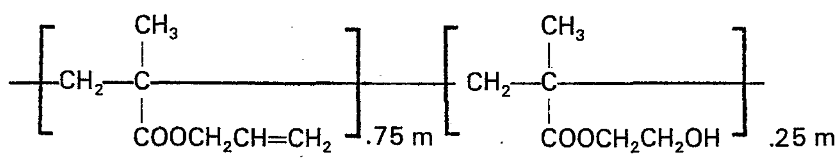

$\overline{Mw}$=76,180; $\overline{Mn}$=24,780; $\overline{Mw}/\overline{Mn}$=3.07.

A 1 liter reaction vessel was equipped with a mechanical stirrer, addition funnel, reflux condensor, nitrogen inlet and immersed in a 80°C constant-temperature bath. A solution of 18.9 g of allyl methacrylate, 6.5 g of 2-hydroxyethyl methacrylate, and 50 mg of 2,2′-azobis(2-methyl propionitrile) in 100 ml of N,N-dimethylformamide (DMF) was added dropwise to 375 ml of stirred, refluxing DMF under nitrogen atmosphere in the aforementioned vessel. Reaction conditions were maintained for 10 hrs. When cool, the reaction solution was added dropwise to 5 liters of water whereupon the polymer precipitated.

The solids were collected on a filter funnel, washed with fresh water and dried in vacuo without heating. 16.9 g yield.

Inherent viscosity, measured at 25°C with 0.25 g of polymer dissolved in 1 dl of 1,2-dichloroethane was 0.11 dl/g. When the solvent was N,N-dimethylformamide the inherent viscosity was 0.13 dl/g.

Elemental analysis:
Calc C 63.8 H 7.9 O 28.3
Found C 63.1 H 8.2 O 28.7

Preparation No. 3

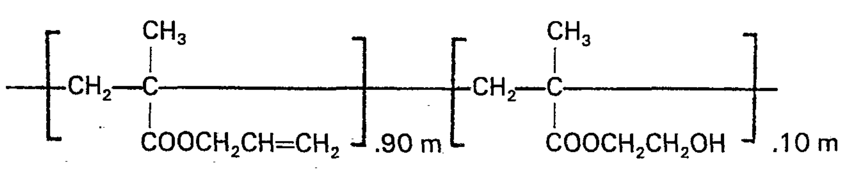

$\overline{Mw}$=60,790; $\overline{Mn}$=17,827; $\overline{Mw}/\overline{Mn}$=3.41.

A solution of 100 g of allyl methacrylate, 11.5 g of 2-hydroxyethyl methacrylate, and 1.11 g of 2,2′-azobis(2-methyl propionitrile) in 500 ml of DCE was added dropwise to 2 liters of stirred refluxing DCE under a nitrogen atmosphere in a reaction vessel similar to that employed in Preparation No. 1. The reaction conditions were maintained overnight (18 hrs). When cool, 2 mg of hydroquinone was dissolved in the reaction solution. One-half of the solvent was removed under a vacuum generated by a water aspirator with minimal heating and 579 ml of 2-ethoxyethyl acetate was added. The remaining DCE in the reaction solution was removed as before. A small sample of the resulting solution was added dropwise to stirred ligroin to precipitate the polymer. The solids were collected on a filter funnel, washed with fresh ligroin, and dried.

Elemental analysis:
% allyl=84 by carbon analysis
Calc C 64.8 H 8.0 O 27.2
Found C 64.8 H 8.6 O 26.6.

Inherent viscosity, measured at a concentration of a 0.25 g/dl, at 25°C was 0.09 dl/g in N,N-dimethylformamide.

As a resist, a solution of the polymer is preferably coated onto the substrate that is to be etched. The resist is then dried, imagewise exposed, and developed to remove the unexposed portions. Any suitable substrate is useful. Particularly preferred substrates include semiconductors such as silicon wafers, chrome-clad glass, and metals such as aluminum.

Conventional solvents are useful for both the coating step and the development step. Preferred examples of solvents useful for either process step include 2-methoxyethyl acetate; 2-ethoxyethyl acetate; 2-ethoxyethanol; 2-butanone and mixtures of these with 2-propanol or ethanol.

Conventional coating procedures are useful to apply the polymer to the substrate. Preferred are whirl or spin coating, brushing, doctor-blade coating, or hopper coating. Further details of such conventional procedures are described in *Product Licensing Index*, Vol. 92, Dec. 1971, Publication No. 9232, at p. 109.

The drying step is conveniently accomplished by baking in an oven, optionally in a vacuum, for example at 90°C for 30 minutes.

Optionally, a post-bake step is included after exposure and development to enhance adhesion of the final resist coating to the areas to be protected, prior to etching. Such treatment is conventional and requires no further discussion.

Etching of the underlying substrate is achieved by using a chemical solvent for the substrate, or by a plasma gas, both of which are conventional. Etch resistance is measured herein as the rate at which the resist is removed by the etchant, in micrometers per minute, to reflect the fact that, for a given electron beam exposure level, the resist will have a different starting thickness, depending on the polymer composition.

The following examples are included for a further illustration of the invention.

Example 1
Poly[allyl methacrylate-co-(2-hydroxyethyl methacrylate)] $(75:25)_m$ resist

A 20% solution of the polymer of Preparation No. 1 in 2-ethoxyethyl acetate was spin-coated onto a chrome-clad glass substrate to provide a thickness of 1 μm after drying at 90°C for 30 minutes. When exposed to an electron beam directed through baffle plates having 6.35 mm diameter holes to achieve uniform electron intensity; at 10 keV, this resist had a sensitivity of $1.1 \times 10^{-7}$ coulombs/cm$^2$.

Examples 2 and 3
Comparison with other polyacrylate resists

The procedure of Example 1 was repeated using the same polymer recurring units in the same ratio as tested in Example 1, except that the polymers were from two different batches of lower molecular weight, coated to produce the same thickness. The weight average molecular weights are indicated in Table I. As a control, poly(allyl methacrylate-co-ethyl methacrylate) $(75:25)_m$ similar to that described in U.S. Patent No. 3,376,138 was obtained, coated and tested. The sensitivities are indicated in Table I.

TABLE I

| Example | Polymer | Mw | Sensitivity (coulombs/cm$^2$) |
|---|---|---|---|
| 2 | Poly[allyl methacrylate-co-(2-hydroxyethyl methacrylate)] $(75:25)_m$ | 23,600 | $2 \times 10^{-7}$ |
| 3 | " " " " | 19,419 | $1.8 \times 10^{-7}$ |
| Control | Poly(allyl methacrylate-co-ethyl methacrylate $(75:25)_m$ | 22,000 | $5 \times 10^{-7}$ |

The results of Table I indicate that substituting ethyl methacrylate for 2-hydroxyethyl methacrylate caused a significantly detrimental reduction in sensitivity, all other factors being essentially equal.

Example 4

Demonstration of improved etch resistance

The procedure of Example 1 was repeated using the same polymer recurring units in the same ratio as tested in Example 1 except that again the molecular weight was altered during the preparation of the polymer as stated in Table II. In addition after exposure at a dosage rate of at least $3\times10^7$ coulombs/cm$^2$ the sample was post baked at 170°C for 30 minutes and plasma etched for 3 minutes using a $(93/4/3)_m$ mixture of $CF_4$, $O_2$ and $N_2$ respectively at 100 $\mu$m pressure and 100 watts power and 20 keV energy. The control was poly(glycidyl methacrylate-co-ethyl acrylate) $(72:28)_m$ similar to the polymer identified in the aforesaid article in *J. Vac. Sci. Technol.* Vol. 15. The resulting etch resistances are listed in Table II.

TABLE II

| Example | Polymer | Mw | Etch resistance ($\mu$m/min) |
|---|---|---|---|
| 4 | Poly[allyl methacrylate-co-(2-hydroxyethyl methacrylate)] $(75:25)_m$ | 48,700 | 0.0175 |
| Control | Poly(glycidyl methacrylate-co-ethyl acrylate) $(72:28)_m$ obtained from KTI/Mead Chemicals Inc. | 192,000 | 0.0350 |

The results of Table II demonstrate that, for plasma etching, and at comparable molecular weights, the resists of the invention tend to be superior to poly(glycidyl methacrylate-co-ethyl acrylate) $(72:28)_m$ because less resist is removed per minute.

When the procedure of Example 4 was repeated using, however, Preparation No. 3 having different comonomer ratio (90:10), it was found that the etch rate of the resist was increased to 0.11 $\mu$m/min. This less desirable result is a further indication of the preference for polymers containing at least 25 mole percent of the hydroxyethyl comonomer.

Examples 5—7

Additional polymer examples

The procedure of Example 1 was repeated, but using instead the resists of the polymers listed in Table III.

TABLE III

| Example | Polymer | Mw | Sensitivity (coulombs/cm$^2$) |
|---|---|---|---|
| 5 | Poly[4-but-1-enyl methacrylate-co-(2-hydroxyethyl methacrylate)] $(75:25)_m$ | 64,100 | $7\times10^{-8}$ |
| 6 | Poly[allyl methacrylate-co-(2-hydroxypropylmethacrylamide)] $(75:25)_m$ | 43,094 | $4.5\times10^{-7}$* |
| 7 | Poly[3-norbornenyl methacrylate-co-(2-hydroxyethyl methacrylate)] $(75:25)_m$ | 64,078 | $8.6\times10^{8}$ |

* Unlike the previous examples this resist was tested using a 20 keV electron beam. As is well known a beam of half that energy increases the sensitivity value and it is estimated such increased value would be well within the $2\times10^7$ coulomb/cm$^2$ criterion.

Comparative Example

The procedure of Example 1 was repeated except that the resist tested was poly[methyl methacrylate-co-(2-hydroxyethyl methacrylate)] $(75:25)_m$ having a weight average molecular weight of 34,900. No sensitivity was ascertainable even at dosages of up to $2\times10^6$ coulombs/cm$^2$ using a 10 keV energy source. This experiment demonstrates the importance of the presence of the allyl group. Furthermore it demonstrates that the poor sensitivity of copolymers containing a hydroxyalkyl *meth*acrylate constituent as reported in British Patent Specification 1 407 312 is not due to the hydroxyalkyl methacrylate but is due rather to the methyl methacrylate constituent.

## Claims

1. A negative-working resist for recording high-energy radiation exposure comprising a copolymer of acrylates and/or methacrylate characterized in that the copolymer has from 50 to 95 mole percent of at least one recurring unit conforming to the structure:

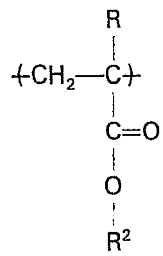

I

and from 5 to 50 mole percent of at least one recurring unit conforming to the structure:

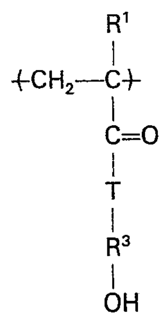

II

wherein:

R and $R^1$ are each independently hydrogen or methyl;

$R^2$ is $—R^4—CH{=}CH_2$ or 3-norbornenyl;

$R^3$ and $R^4$ are each independently alkylene having from 1 to 3 carbon atoms; and

T is —O— or —NH—; and in that

said resist is sensitive to exposure with an electron beam of up to $2.0 \times 10^{-7}$ coulomb/cm$^2$ at 10 keV.

2. A negative-working resist according to Claim 1, characterized in that R and $R^1$ are each methyl; $R^2$ is $—R^4—CH{=}CH_2$; and $R^3$ is ethylene.

3. A negative-working resist according to Claim 2, characterized in that $R^4$ is methylene; and T is —O—.

4. A negative-working resist according to Claim 2, characterized in that $R^4$ is ethylene and T is —O—.

5. A negative-working resist according to Claim 1, characterized in that R and $R^1$ are each methyl; $R^2$ is $—R^4—CH{=}CH_2$ wherein $R^4$ is methylene; $R^3$ is propylene and T is —NH—.

6. A negative-working resist according to Claim 1, characterized in that R and $R^1$ are each methyl; $R^2$ is 3-norbornenyl; $R^3$ is ethylene and T is —O—.

7. A negative-working resist according to any one of Claims 3 to 6, characterized in that the copolymer contains from 70 to 75 mole percent of recurring units conforming to structure I and from 25 to 30 mole percent of recurring units conforming to structure II.

## Patentansprüche

1. Negativ arbeitendes Resist für die Aufzeichnung von Hochenergiestrahlung mit einem Copolymer von Acrylaten und/oder Methacrylaten, dadurch gekennzeichnet, daß das Copolymer 50 bis 95 Mol-% mindestens einer wiederkehrenden Einheit der folgenden Formel:

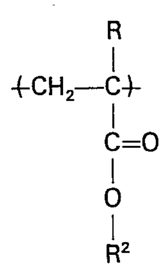

I

und 5 bis 50 Mol-% mindestens einer wiederkehrenden Einheit der folgenden Formel:

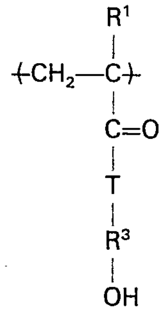

II

enthält, worin bedeuten:

R und $R^1$ jeweils unabhängig voneinander ein Wasserstoffatom oder einen Methylrest;

$R^2$ den Rest $—R^4—CH=CH_2$ oder einen 3-Norbornenylrest;

$R^3$ und $R^4$ jeweils unabhängig voneinander einen Alkylenrest mit 1 bis 3 Kohlenstoffatomen und

T —O— oder —NH—,

und daß das Resist empfindlich gegenüber einer Exponierung mit einem Elektronenstrahl von bis zu $2{,}0 \times 10^{-7}$ Coulomb/$cm^2$ bei 10 KeV ist.

2. Negativ arbeitendes Resist nach Anspruch 1, dadurch gekennzeichnet, daß R und $R^1$ jeweils einen Methylrest darstellen; $R^2$ ein Rest der Formel $—R^4—CH=CH_2$ ist und $R^3$ für einen Ethylenrest steht.

3. Negativ arbeitendes Resist nach Anspruch 2, dadurch gekennzeichnet, daß $R^4$ für einen Methylenrest und T für —O— stehen.

4. Negativ arbeitendes Resist nach Anspruch 2, dadurch gekennzeichnet, daß $R^4$ für einen Ethylenrest und T für —O— stehen.

5. Negativ arbeitendes Resist nach Anspruch 1, dadurch gekennzeichnet, daß R und $R^1$ jeweils für einen Methylrest; $R^2$ für einen Rest der Formel $—R^4—CH=CH_2$, worin $R^4$ ein Methylenrest ist; $R^3$ für einen Propylenrest und T für einen Rest der Formel —NH— stehen.

6. Negativ arbeitendes Resist nach Anspruch 1, dadurch gekennzeichnet, daß R und $R^1$ jeweils für einen Methylrest; $R^2$ für einen 3-Norbornenylrest; $R^3$ für einen Ethylenrest und T für —O— stehen.

7. Negativ arbeitendes Resist nach einem der Ansprüche 3 bis 6, dadurch gekennzeichnet, daß das Copolymer 70 bis 75 Mol-% wiederkehrende Einheiten der Formel I und 25 bis 30 Mol-% wiederkehrende Einheiten der Formel II enthält.

**Revendications**

1. Réserve fonctionnant en négatif pour l'enregistrement d'expositions à un rayonnement d'énergie élevée, comprenant un copolymère d'acrylates et/ou de méthacrylates, caractérisée en ce que le copolymère contient de 50 à 95 moles pour cent d'au moins un motif présentant la structure:

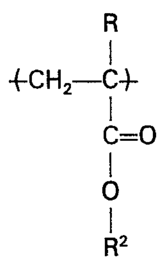

I

et de 5 à 50 moles pour cent d'au moins un motif présentant la structure:

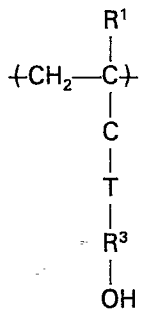

II

structures dans lesquelles:

R et $R^1$ sont chacun indépendament un atome d'hydrogène ou un groupe méthyle;
$R^2$ représente un groupe $—R^4—CH=CH_2$ ou 3-norbornényle;
$R^3$ et $R^4$ sont chacun indépendament un groupe alkylène ayant de 1 à 3 atomes de carbone; et
T représente —O— ou —NH—;

et en ce que la dite réserve est sensible à des expositions avec un faisceau d'électrons pouvant atteindre $2{,}0 \times 10^{-7}$ coulombs/$cm^2$ à 10 keV.

2. Réserve fonctionnant en négatif conforme à la revendication 1, caractérisée en ce que R et $R^1$ sont chacun un groupe méthyle, $R^2$ représente $—R^4—CH=CH_2$ et $R^3$ est un groupe éthylène.

3. Réserve fonctionnant en négatif conforme à la revendication 2, caractérisée en ce que $R^4$ est un groupe méthylène et T représente —O—.

4. Réserve fonctionnant en négatif conforme à la revendication 2, caractérisée en ce que $R^4$ est un groupe éthylène et T représente —O—.

5. Réserve fonctionnant en négatif conforme à la revendication 1, caractérisée en ce que R et $R^1$ sont chacun un groupe méthyle; $R^2$ représente un groupe $—R^4—CH=CH_2$, dans lequel $R^4$ est un groupe méthylène; $R^3$ est un groupe propylène et T représente —NH—.

6. Réserve fonctionnant en négatif conforme à la revendication 1, caractérisée en ce que R et $R^1$ sont chacun un groupe méthyle; $R^2$ est un groupe 3-norbornényle; $R^3$ est un groupe éthylène et T représente —O—.

7. Réserve fonctionnant en négatif conforme à l'une quelconque des revendications 3 à 6, caractérisée en ce que le copolymère contient de 70 à 75 moles pour cent de motifs présentant la structure I et de 25 à 30 moles pour cent de motifs présentant la structure II.